(19) Europäisches Patentamt
European Patent Office
Office européen des brevets

(11) EP 4 465 317 A1

(12) EUROPEAN PATENT APPLICATION

(43) Date of publication:
**20.11.2024 Bulletin 2024/47**

(21) Application number: **23173781.8**

(22) Date of filing: **16.05.2023**

(51) International Patent Classification (IPC):
***H01G 9/00*** *(2006.01)* ***H01G 9/028*** *(2006.01)*
***H01G 9/15*** *(2006.01)* *H01G 11/48 (2013.01)*
*H01B 1/12 (2006.01)* *C08G 61/12 (2006.01)*

(52) Cooperative Patent Classification (CPC):
**H01G 9/028; C08G 61/12; C08G 61/126; C08L 65/00; C09D 165/00; H01B 1/127; H01G 9/0036; H01G 9/15;** C08G 2261/1424; C08G 2261/3223; C08G 2261/794; H01G 11/48; H10K 85/1135

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Heraeus Epurio GmbH**
**63450 Hanau (DE)**

(72) Inventors:
- **Lövenich, Wilfried**
  **51368 Leverkusen (DE)**
- **Merker, Udo**
  **51368 Leverkusen (DE)**
- **Elschner, Andreas**
  **51368 Leverkusen (DE)**
- **Sautter, Armin**
  **51368 Leverkusen (DE)**

(74) Representative: **Herzog IP Patentanwalts GmbH**
**Steinstraße 16-18**
**40212 Düsseldorf (DE)**

(54) **PEDOT-DISPERSION WITH LOW NUMBER OF PARTICLES**

(57) The present invention relates to a dispersion comprising
**i)** a dispersant;
**ii)** at least one polythiophene dispersed in the dispersant i);

wherein the dispersion comprises less than 10,000 particles per ml that have a particle size of 1.5 μm or more; and
wherein a conductive layer prepared from the dispersion has a conductivity of more than 10 S/cm as determined by the test method disclosed herein.

The invention also relates to a process for the preparation of a dispersion, to a dispersion obtainable by that process, to a process for the preparation of a layered body, to a layered body obtainable by that process and to the use of a dispersion for the formation of a solid electrolyte layer in a capacitor.

Fig. 2

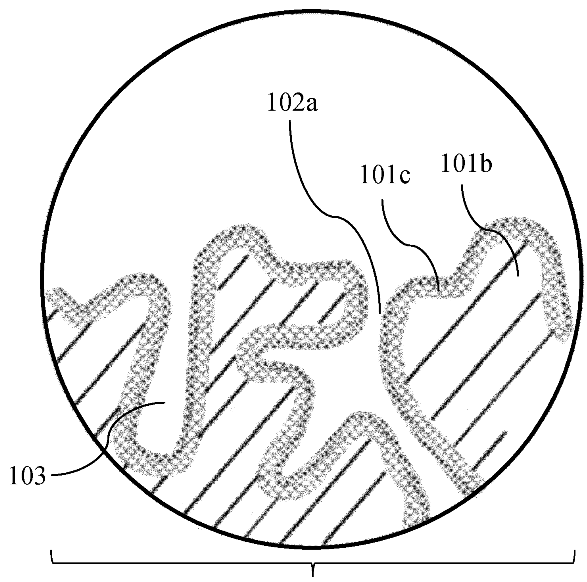




Processed by Luminess, 75001 PARIS (FR)

## Description

### FIELD OF THE INVENTION

The present invention relates to a dispersion comprising a dispersant and at least one polythiophene dispersed in the dispersant, to a process for the preparation of a dispersion, to a dispersion obtainable by that process, to a process for the preparation of a layered body, to a layered body obtainable by that process and to the use of a dispersion for the formation of a solid electrolyte layer in a capacitor.

### BACKGROUND OF THE INVENTION

A standard electrolytic capacitor generally consists of a porous metal electrode, an oxide layer disposed on the metallic surface, an electrically conductive material, generally a solid, which is introduced into the porous structure, an external electrode (contact), such as a silver layer, and other electrical contacts and an encapsulation. One frequently used electrolytic capacitor is the tantalum electrolytic capacitor, of which the anode electrode is made from the valve metal tantalum, on which a uniform, dielectric layer of tantalum pentoxide has been produced through anodic oxidation (also referred to as "*forming*"). A liquid or solid electrolyte forms the cathode of the capacitor. Aluminium capacitors, of which the anode electrode is made from the valve metal aluminium, on which a uniform, electrically insulating aluminium oxide layer is produced as a dielectric by means of anodic oxidation, are also frequently used. Here also, a liquid electrolyte or a solid electrolyte form the cathode of the capacitor. The aluminium capacitors are generally embodied as wound capacitors or stack-type capacitors.

In view of their high electrical conductivity, $\pi$-conjugated polymers are particularly suitable as solid electrolytes in the capacitors described above. $\pi$-conjugated polymers are also referred to as conductive polymers or as synthetic metals. They are gaining increasing commercial significance because, by comparison with metals, polymers have advantages with regard to processing, weight and the selective adjustment of properties through chemical modification. Examples of known $\pi$-conjugated polymers include polypyrroles, polythiophenes, polyanilines, polyacetylenes, polyphenylenes and poly(p-phenylene-vinylenes), wherein poly(3,4-ethylene-dioxythiophene) (PEDOT) is a particularly important polythiophene which is used technically, because it has a very high conductivity in its oxidised form.

In the prior art, alternative methods for manufacturing solid electrolytes based on conductive polymers in electrolytic capacitors have therefore been developed. For example, DE-A-10 2005 043828 describes a process for manufacturing solid electrolytes in capacitors, in which a dispersion comprising polythiophenes, for example, the PEDOT/PSS-dispersion known from the prior art, is applied to the oxide layer, and then the dispersion medium is removed by evaporation.

However, it has been observed that the capacitance of electrolyte capacitors having a solid electrolyte layer which has been prepared using conventional PEDOT/PSS-dispersions is for certain applications often not high enough.

The present invention was based on the object of overcoming the disadvantages resulting from the prior art in connection with capacitors, preferably in connection with electrolytic capacitors, more preferably in connection with capacitors known from the prior art that comprise a solid electrolyte layer based on $\pi$-conjugated polymers such a PEDOT, even more preferably in connection with capacitors known from the prior art that comprise a solid electrolyte layer based on PEDOT/PSS.

In particular, the present invention was based on the object of providing dispersions comprising at least one polythiophene, preferably dispersions comprising a complex of a polythiophene and a polyanion, more preferably dispersions comprising a PEDOT/PSS-complex, that are particularly useful for the preparation of solid electrolyte layers in capacitors that are characterized by a high capacitance.

It was also an object of the present invention to provide a process by means of which such advantageous dispersions can be prepared. The process for the preparation of the advantageous dispersions should be characterized in that it allows the manufacture of these dispersions in the simplest possible manner, in particular with the fewest possible process steps.

Moreover, it was an object of the present invention to provide a process for the preparation of a layered body, preferably for the preparation of an electrolyte capacitor, wherein the electrolyte capacitor compared to electrolyte capacitors known from the prior art is characterized by an increased capacitance.

### SUMMARY OF THE INVENTION

A contribution to at least partly solving at least one, preferably more than one, of the above objects is made by the independent claims. The dependent claims provide preferred embodiments which contribute to at least partly solving at least one of the objects.

**|1a|** A contribution to solving at least one of the objects according to the invention is made by a 1st embodiment of a dispersion comprising

**i)** a dispersant (also referred to as a "*dispersing agent*");

**ii)** at least one polythiophene dispersed in the dispersant **i)**;

wherein the dispersion comprises less than 10,000 (*i. e.* $10^4$) particles per ml that have a particle size of 1.5 μm or more, wherein it is preferred that the dispersion comprises 1,000 to 10,000 such particles per ml, more preferably 1,500 to 9,000 such particles per ml, even more preferably 2,000 to 8,000 such particles per ml and most preferably 2,000 to 7,000 such particles per ml; and

wherein a conductive layer prepared from the dispersion has a conductivity of more than 10 S/cm, preferably of more than 50 S/cm, more preferably of more than 100 S/cm, even more preferably of more than 200 S/cm and most preferably of more than 300 S/cm as determined by the test method disclosed herein (i. e., by a test method in which the conductivity of a conductive layer is determined for a dispersion that is obtained after 19 g of the dispersion according to the present invention have been supplemented with 1 g DMSO).

The term "*dispersion*" as used in context with the present invention general refers to any liquid composition in which a polythiophene, for example a polythiophene that is part of a complex comprising the polythiophene and a polyanion, is somehow distributed in a homogeneous phase that is formed by the liquid dispersant **i)** (dispersant **i)** thus forms the liquid phase of the dispersion). It should be noted that transitions between a "*dispersion*" and a "*solution*" can be fluid. For that reason, no distinction is made hereafter between the terms "*dispersed*" and "*dissolved*". Likewise, no distinction is made between "*dispersion*" and "*solution*" or between "*dispersant*" and "*solvent*". Rather these terms are used synonymously hereafter.

**|2a|** According to a preferred embodiment of the dispersion according to the invention, the dispersion comprises less than 2,000 particles per ml that have a particle size of 10 μm or more, preferably less than 1,500 such particles per ml, more preferably less than 1,000 such particles per ml, even more preferably less than 800 such particles per ml and most preferably less than 600 such particles per ml. This preferred embodiment is a 2nd embodiment of the dispersion according to the present invention, that preferably depends on the 1st embodiment.

**|3a|** According to a further preferred embodiment of the dispersion according to the invention, the polythiophene **ii)** is present in the form of particles of a complex comprising the polythiophene and a polyanion and wherein the number and the size of the particles defined in the 1st and the 2nd embodiment of the dispersion according to the present invention refers to the number and the size of the particles of a complex comprising the polythiophene and a polyanion. This preferred embodiment is a 3rd embodiment of the dispersion according to the present invention, that preferably depends on the 1st or the 2nd embodiment.

**|4a|** According to a preferred embodiment of the dispersion according to the invention, the dispersant **i)** comprises water. Preferably, dispersant **i)** comprises water in an amount of at least 50 wt.-%, more preferably at least 65 wt.-%, even more preferably at least 70 wt.-% and most preferably at least 80 wt.-%, in each case based on the total weight of the dispersion. This preferred embodiment is a 4th embodiment of the dispersion according to the present invention, that preferably depends on any of the 1st to the 3rd embodiment.

**|5a|** According to a further preferred embodiment of the dispersion according to the invention, the at least one polythiophene **ii)** is a foreign-doped polythiophene, such as a cationic polythiophene that is present in the form of a polythiophene/polyanion-complex, more preferably in the form of a PEDOT/PSS-complex, a self-doped polythiophene, such as poly(4-[(2,3-dihydrothieno-[3,4-b]-[1,4]dioxin-2-yl)methoxy]propane-1-sulfonic acid), poly(4-[(2,3-dihydro-thieno-[3,4-b][1,4]dioxin-2-yl)methoxy]butane-1-sulfonic acid) (PEDOT-S) or poly-(4-[(2,3-dihydrothieno[3,4-b][1,4]dioxin-2-yl)methoxy]butane-2-sulfonic acid), or a mixture thereof. This preferred embodiment is a 5th embodiment of the dispersion according to the present invention, that preferably depends on any of the 1st to the 4th embodiment.

**|6a|** According to a further preferred embodiment of the dispersion according to the invention, the at least one polythiophene **ii)** is present in the form of particles of a complex comprising the at least one polythiophene **ii)** and a polyanion. This preferred embodiment is a 6th embodiment of the dispersion according to the present invention, that preferably depends on any of the 1st to the 5th embodiment.

**|7a|** According to a further preferred embodiment of the dispersion according to the invention, the at least one polythiophene **ii)** is present in the form of particles of a complex comprising the at least one polythiophene **ii)** and a polyanion, wherein the polythiophene is poly(3,4-ethylenedioxythiophene) and the polyanion is an anion of polystyrene sulfonic acid. The complex of the polythiophene and the polyanion is thus preferably a PEDOT/PSS-complex. This preferred embodiment is a 7th embodiment of the dispersion according to the present invention, that preferably depends on any of the 1st to the 6th embodiment.

**|8a|** According to a further preferred embodiment of the dispersion according to the invention, the at least one polythiophene **ii)** is present in the form of particles of a complex comprising the at least one polythiophene **ii)** and a polyanion, preferably in the form of particles comprising PEDOT/PSS, wherein the dispersion comprises the polyanion and the polythiophene in a weight ratio polyanion : polythiophene in the range from of 0.5 : 1 to 30 : 1, preferably in the range from of 0.8 : 1 to 15 : 1, more preferably in the range from 1 : 1 to 10 : 1, even more preferably in the range from 1.2 : 1 to 8 : 1 and most preferably in the range from 1.4 : 1 to 4 : 1. The weight of the polythiophene in this context corresponds to the weighed amount of the thiophene monomers used for the preparation of the polythiophene, on the assumption that a complete conversion takes place during the polymerisation. This preferred embodiment is an 8th embodiment of the dispersion according to the present invention, that preferably depends on any of the 1st to the 7th embodiment.

**|9a|** According to a further preferred embodiment of the dispersion according to the invention, the at least one polythiophene **ii)** is present in the form of particles of a complex comprising the at least one polythiophene **ii)** and a polyanion, preferably in the form of particles comprising PEDOT/PSS, wherein the weight average diameter ($\mathbf{d_{50}}$) as determined by ultra-centrifuge measurement of these particles is in the range from 1 nm to 100 nm, more preferably in the range from 2 nm to 50 nm, even more preferably in the range from 3 nm to 40 nm and most preferably in the range from 4 nm to 30 nm. This preferred embodiment is a 9th embodiment of the dispersion according to the present invention, that preferably depends on any of the 1st to the 8th embodiment.

**|10a|** According to a further preferred embodiment of the dispersion according to the invention, the at least one polythiophene **ii)** is present in the form of particles of a complex comprising the at least one polythiophene **ii)** and a polyanion, preferably in the form of particles comprising PEDOT/PSS, wherein the dispersion has a $\mathbf{d_{90}}$-value of the diameter distribution of these particles as determined by ultra-centrifuge measurement of less than 100 nm, preferably less than 80 nm, more preferably less than 60 nm and most preferably less than 50 nm. This preferred embodiment is a 10th embodiment of the dispersion according to the present invention, that preferably depends on any of the 1st to the 9th embodiment.

**|11a|** According to a further preferred embodiment of the dispersion according to the invention, the at least one polythiophene **ii)** is present in the form of particles of a complex comprising the at least one polythiophene **ii)** and a polyanion, preferably in the form of particles comprising PEDOT/PSS, wherein the dispersion has a $\mathbf{d_{10}}$-value of the diameter distribution of these particles as determined by ultra-centrifuge measurement of greater than 1 nm, preferably greater than 2 nm, more preferably greater than 3 nm and most preferably greater than 4 nm. This preferred embodiment is an 11th embodiment of the dispersion according to the present invention, that preferably depends on any of the 1st to the 10th embodiment.

|**12a|** According to a further preferred embodiment of the dispersion according to the invention, the dispersion has a pH-value (determined at 25°C) in the range from 2.5 to 8.0, preferably in the range from 2.5 to 7 and more preferably in the range from 3 to 6. This preferred embodiment is a 12th embodiment of the dispersion according to the present invention, that preferably depends on any of the 1st to the 11th embodiment.

**|13a|** According to a further preferred embodiment of the dispersion according to the invention, the at least one polythiophene **ii)** is present in the form of particles of a complex comprising the at least one polythiophene **ii)** and a polyanion, preferably in the form of particles comprising PEDOT/PSS, wherein the dispersion comprises the polythiophene and the polyanion in a total amount (*i. e.*, the amount of polythiophene plus the amount of polyanion) of at least 1 wt.-%, preferably of at least 1.4 wt.-%, more preferably of at least 1.6 wt.-%, even more preferably of at least 1.7 wt.-% and most preferably of at least 1.8 wt.-%, in each case based on the total weight of the dispersion. This preferred embodiment is a 13th embodiment of the dispersion according to the present invention, that preferably depends on any of the 1st to the 12th embodiment.

**|14a|** According to a further preferred embodiment of the dispersion according to the invention, the dispersion further comprises

**iii)** at least one additive, wherein the at least one additive is an additive selected from the group consisting of a binder, a pH-regulator, a crosslinker, an adhesion promoter, a conductivity improver, a surfactant, a stabilizer and a combination of at least two of these additives.
This preferred embodiment is a 14th embodiment of the dispersion according to the present invention, that preferably depends on any of the 1st to the 13th embodiment.

**|15a|** According to a further preferred embodiment of the dispersion according to the invention, the dispersion has a solids content of at least 1 wt.-%, preferably of at least 1.4 wt.-%, more preferably of at least 1.6 wt.-%, even more preferably of at least 1.8 wt.-% and most preferably of at least 2.0 wt.-%, in each case based on the total weight of the dispersion. This preferred embodiment is a 15th embodiment of the dispersion according to the present invention, that preferably depends on any of the 1st to the 14th embodiment.

**|16a|** According to a further preferred embodiment of the dispersion according to the invention, the dispersion has a viscosity (measured with a rheometer at 20°C and a shear rate of 100 $s^{-1}$) in the range from 0.1 to 200 mPa×s, preferably in the range from 1 to 100 mPa×s, more preferably in the range from 5 to 70 mPa×s and most preferably in the range from 10 to 50 mPa×s. This preferred embodiment is a 16th embodiment of the dispersion according to the present invention, that preferably depends on any of the 1st to the 15th embodiment.

**|1b|** A contribution to solving at least one of the objects according to the invention is also made by a 1st embodiment of a process 1 for the preparation of a dispersion comprising the steps:

**I)** providing a dispersion comprising

**i)** a dispersant;

**ii)** at least one polythiophene dispersed in the dispersant i);

by polymerizing thiophene monomers in the presence of the dispersant i);

wherein the dispersion has a solids content of at least 1.8 wt.-%, preferably of at least 1.9 wt.% and even more preferably of at least 2.0 wt.-%, in each case based on the total weight of the dispersion;

and wherein the dispersion has a conductivity of more than 10 S/cm, preferably of more than 50 S/cm, more preferably of more than 100 S/cm, even more preferably of more than 200 S/cm and most preferably of more than 300 S/cm as determined by the test method disclosed herein;

**II)** adjusting the size of particles that have a particle size of 1.5 μm or more in the dispersion provided in process step **I)** to be not more than 10,000 per ml, preferably to be in the range from 1,000 to 10,000 per ml, more preferably to be in the range from 1,500 to 9,000 per ml, even more preferably to be in the range from 2,000 to 8,000 per ml and most preferably to be in the range from 2,000 to 7,000 per ml.

**|2b|** According to a preferred embodiment of process 1 according to the invention, the dispersant **i)** comprises water. Preferably, dispersant **i)** comprises water in an amount of at least 50 wt.-%, more preferably at least 65 wt.-%, even more preferably at least 70 wt.-% and most preferably at least 80 wt.-%, in each case based on the total weight of the dispersion provided in process step **I)**. This preferred embodiment is a 2nd embodiment of process 1 according to the present invention, that preferably depends on the 1st embodiment.

**|3b|** According to a further preferred embodiment of process 1 according to the invention, the thiophene monomer is polymerized in the presence of the dispersant **i)** and in the presence of a polyanion to obtain a dispersion comprising a complex of a polythiophene and the polyanion. This preferred embodiment is a 3rd embodiment of process 1 according to the present invention, that preferably depends on the 1st or the 2nd embodiment.

**|4b|** According to a further preferred embodiment of process 1 according to the invention, the thiophene monomer is polymerized in the presence of the dispersant **i)** and in the presence of a polyanion to obtain a dispersion comprising a complex of a polythiophene and the polyanion, wherein the thiophene monomer is 3,4-ethylenedioxythiophene and the polyanion is an anion of polystyrene sulfonic acid. The complex of the polythiophene and the polyanion is thus preferably a PEDOT/PSS-complex. This preferred embodiment is a 4th embodiment of process 1 according to the present invention, that preferably depends on any of the 1st to the 3rd embodiment.

**|5b|** According to a further preferred embodiment of process 1 according to the invention, the thiophene monomer is polymerized in the presence of the dispersant **i)** and in the presence of a polyanion to obtain a dispersion comprising a complex of a polythiophene and the polyanion, preferably a PEDOT/PSS-complex, wherein the polyanion and the thiophene monomer are polymerized in a weight ratio polyanion : thiophene monomer in the range from of 0.5 : 1 to 30 : 1, preferably in the range from of 0.8 : 1 to 15 : 1, more preferably in the range from 1 : 1 to 10 : 1, even more preferably in the range from 1.2 : 1 to 8 : 1 and most preferably in the range from 1.4 : 1 to 4 : 1. This preferred embodiment is a 5$^{th}$ embodiment of process 1 according to the present invention, that preferably depends on any of the 1$^{st}$ to the 4$^{th}$ embodiment.

**|6b|** According to a further preferred embodiment of process 1 according to the invention, adjustment of the number of particles that have a particle size of 1.5 $\mu$m or more in the dispersion provided in process step **I)** is accomplished by means of a process selected from the group consisting of

- subjecting the dispersion provided in process step **I)** to homogenization, preferably to high-pressure homogenization, followed by a step of subjecting the dispersion to a sequence of two or more filtration steps, preferably to a sequence of two or more filtration steps using filters with a cut off size which is reduced stepwise from filtration step to filtration step;

- subjecting the dispersion provided in process step **I)** to homogenization, preferably to high-pressure homogenization, more preferably to a sequence of at least 25, preferably of at least 35, more preferably of at least 45, even more preferably of at least 55 and most preferably of at least 65 high-pressure homogenization steps performed at a pressure of at least 1,000 bar, preferably at a pressure of at least 1,200 bar, more preferably at a pressure of at least 1,400 bar, even more preferably at a pressure of at least 1,600 bar and most preferably at a pressure of at least 1,800 bar, followed by a step of subjecting the dispersion to filtration using a filter with a cut off size of less than 1 $\mu$m;

- a combination of the two approaches described above.

This preferred embodiment is a 6$^{th}$ embodiment of process 1 according to the present invention, that preferably depends on any of the 1$^{st}$ to the 5$^{th}$ embodiment.

**|7b|** According to a further preferred embodiment of process 1 according to the invention, adjustment of the number of particles that have a particle size of 1.5 $\mu$m or more in the dispersion provided in process step **I)** is accomplished by means of a process comprising the process steps:

**IIa)** subjecting the dispersion provided in process step **I)** to a sequence of at least 10, preferably of at least 15, more preferably of at least 20, even more preferably of at least 25 and most preferably of at least 30 high-pressure homogenization steps performed at a pressure of at least 1,000 bar;

**IIb)** subjecting the dispersion obtained in process step **IIa)** to a first filtration step, wherein the dispersion is filtered through a filter having a cut off size in the range from 5 to 20 $\mu$m, preferably in the range from 10 to 20 $\mu$m, wherein filtration is preferably accomplished under a pressure of not more than 1 bar, preferably not more than 0.8 bar, more preferably not more than 0.6 bar, even more preferably not more than 0.4 bar and most preferably not more than 0.2 bar;

**IIc)** subjecting the dispersion obtained in process step **IIb)** to a further filtration step, wherein the dispersion is filtered through a filter having a cut off size in the range from 0.01 to 1 $\mu$m, preferably in the range from 0.05 to 0.8 $\mu$m, more preferably in the range from 0.1 to 0.6 $\mu$m, even more preferably in the range from 0.1 to 0.45 $\mu$m and most preferably in the range from 0.1 to 0.2 $\mu$m, wherein filtration is preferably performed under a pressure of not more than 1 bar, preferably not more than 0.8 bar, more preferably not more than 0.6 bar, even more preferably not more than 0.4 bar and most preferably not more than 0.2 bar.

This preferred embodiment is a 7$^{th}$ embodiment of process 1 according to the present invention, that preferably depends on any of the 1$^{st}$ to the 6$^{th}$ embodiment.

**|8b|** According to a further preferred embodiment of process 1 according to the invention, adjustment of the number of particles that have a particle size of 1.5 $\mu$m or more in the dispersion provided in process step **I)** is accomplished by means of a process comprising the process steps:

**IIa)** subjecting the dispersion provided in process step **I)** to a sequence of at least 25, preferably of at least 35, more preferably of at least 45, even more preferably of at least 55 and most preferably of at least 65 high-pressure homogenization steps performed at a pressure of at least 1,000 bar, preferably at a pressure of at least 1,200 bar, more preferably at a pressure of at least 1,400 bar, even more preferably at a pressure of at least 1,600 bar and most preferably at a pressure of at least 1,800 bar, wherein according to a particular embodiment of the process homogenization in step **IIa)** is performed in two stages with the first (initial) homogenization stage performed at a pressure of at least 1000 bar and the second homogenization stage performed at a pressure of at least 1800 bar;

**IIb)** subjecting the dispersion obtained in process step **IIa)** to a filtration step, wherein the dispersion is filtered through a filter having a cut off size in the range from 0.01 to 1 μm, preferably in the range from 0.05 to 0.8 μm, more preferably in the range from 0.1 to 0.6 μm, even more preferably in the range from 0.1to 0.4 μm and most preferably in the range from 0.1 to 0.2 μm, wherein filtration is preferably accomplished under a pressure of not more than 1 bar, preferably not more than 0.8 bar, more preferably not more than 0.6 bar, even more preferably not more than 0.4 bar and most preferably not more than 0.2 bar.

This preferred embodiment is an 8th embodiment of process 1 according to the present invention, that preferably depends on any of the 1st to the 6th embodiment.

**|1c|** A contribution to solving at least one of the objects according to the invention is also made by a dispersion obtainable by process 1 according to the present invention, preferably by process 1 according to any of its 1st to the 8th embodiment. Preferably, this dispersion has the same properties as the dispersion according to the present invention, preferably as the dispersion according to the present invention as defined in any of its 1st to the 16th embodiment.

**|1d|** A contribution to solving at least one of the objects according to the invention is also made by a 1st embodiment of a process 2 for the preparation of a layered body, comprising the process steps:

**A)** provision of a substrate ;

**B)** application of the dispersion according to the present invention, preferably of the dispersion according to the present invention as defined in any of its 1st to the 16th embodiment, or of a dispersion obtainable by process 1 according to the present invention, preferably by process 1 as defined in any of its 1st to the 8th embodiment, onto at least a part of the surface of this substrate;

**C)** at least partial removal of the dispersant **i)** to obtain a layered body comprising an electrically conductive layer coated onto at least a part of the surface of the substrate.

**|2d|** According to a preferred embodiment of process 2 according to the invention, the layered body is part of an electrolyte capacitor, wherein the substrate is a porous electrode body made of an electrode material, wherein a dielectric layer at least partially covers a surface of this electrode material and wherein the electrically conductive layer is a solid electrolyte layer that at least partially covers a surface of the dielectric layer. This preferred embodiment is a 2nd embodiment of process 2 according to the present invention, that preferably depends on the 1st embodiment.

**|3d|** According to a preferred embodiment of process 2 according to the invention, the process comprises the steps of:

**A)** provision of a porous electrode body made of an electrode material, wherein a dielectric layer at least partially covers a surface of this electrode material;

**B)** introduction of the dispersion according to the present invention, preferably of the dispersion according to the present invention as defined in any of its 1st to the 16th embodiment, or of a dispersion obtainable by process 1 according to the present invention, preferably by process 1 as defined in any of its 1st to the 8th embodiment, into at least a part of the porous electrode body provided in process step **A)** so as to apply the dispersion onto and at least a part of the surface of the dielectric layer;

**C)** at least partial removal of the dispersant **i)** for the formation of a solid electrolyte that at least partially covers a surface of the dielectric layer;

**D)** optionally application of a dispersion containing a conductive polymer, preferably a dispersion comprising a polythiophene and a dispersant, more preferably a dispersion comprising a dispersant and particles of a complex of a polythiophene and a polymeric anion, even more preferably a PEDOT/PSS-dispersion, onto at least a part of the surface of the solid electrolyte layer and at least partial removal of the dispersant for the formation of a polymeric outer layer that at least partially covers a surface of the solid electrolyte layer.

This preferred embodiment is a 3rd embodiment of process 2 according to the present invention, that preferably depends on the 1st or the 2nd embodiment.

**|4d|** According to a further preferred embodiment of process 2 according to the invention, the layered body is an aluminum capacitor or a tantalum capacitor. This preferred embodiment is a 4th embodiment of process 2 according to the present invention, that preferably depends to any of its 1st to the 3rd embodiment.

**|1e|** A contribution to solving at least one of the objects according to the invention is also made by a layered body obtainable by process 2 according to the present invention, preferably by process 2 according to any of its 1st to the 4th embodiment.

**|1f|** A contribution to solving at least one of the objects according to the invention is also made by the use of the dispersion according to the present invention, preferably of the dispersion according to the present invention as defined in any of its 1st to the 16th embodiment, or of a dispersion obtainable by process 1 according to the present invention, preferably by process 1 as defined in any of its 1st to the 8th embodiment, for the formation of a solid electrolyte layer in a capacitor.

**|2f|** According to a preferred embodiment of the use according to the invention, the capacitor is an aluminum capacitor or a tantalum capacitor. This preferred embodiment is 2nd embodiment of the use according to the present invention, that preferably depends on the 1st embodiment.

**DETAILED DESCRIPTION**

Polythiophenes

The dispersion according to the present invention comprises a dispersant and at least one polythiophene dispersed in the dispersant.

Preferred polythiophenes are those with repeat units of the general formula (I), of the general formula (II), of the general formula (III) or polythiophenes comprising combinations of these repeat units:

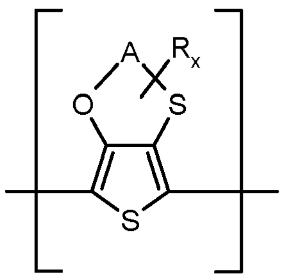

(I)

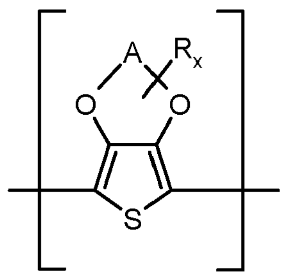

(II)

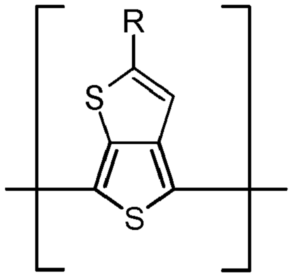

(III)

in which

A is an optionally substituted $C_1$-$C_5$-alkylene radical,

R is independently H, a linear or branched, optionally substituted $C_1$-$C_{18}$-alkyl radical, an optionally substituted $C_5$-$C_{12}$-cycloalkyl radical, an optionally substituted $C_6$-$C_{14}$-aryl radical, an optionally substituted $C_7$-$C_{18}$-aralkyl radical, an optionally substituted $C_1$-$C_4$-hydroxyalkyl radical or a hydroxyl radical,

x is an integer from 0 to 8 and,

in the case that a plurality of R radicals are bonded to A, they may be the same or different.

The general formulae (I) and (II) should be understood such that x substituents R may be bonded to the alkylene radical A.

Particular preference is given to polythiophenes with repeat units of the general formula (I) or (II) or repeat units of the general formulae (I) and (II), in which A is an optionally substituted $C_2$-$C_3$-alkylene radical and x is 0 or 1. A very particularly preferred polythiophene is poly(3,4-ethylenedioxythiophene) (PEDOT), which is optionally substituted, as in poly(4-[(2,3-dihydrothieno[3,4-b]-[1,4]dioxin-2-yl)methoxy]propane-1-sulfonic acid), poly(4-[(2,3-dihydro-thieno[3,4-b][1,4]di-oxin-2-yl)methoxy]butane-1-sulfonic acid) (PEDOT-S) or poly(4-[(2,3-dihydro-thieno[3,4-b][1,4]dioxin-2-yl)methoxy]butane-2-sulfonic acid).

In the context of the invention, the prefix "*poly*" should be understood to mean that more than one identical or different repeat unit is present in the polymer or polythiophene. The polythiophenes contain a total of n repeat units of the general formula (I) or of the general formula (II) or of the general formula (III) or of the general formulae (I) and (II) or of the general formulae (I) and (III) or of the general formulae (II) and (III) or of the general formulae (I), (II) and (III), where n is an integer of 2 to 2000, preferably 2 to 100. The repeat units of the general formula (I) or of the general formula (II) or of the general formula (III) or the repeat units of the general formulae (I) and (II) or the repeat units of the general formulae (I) and (III) or the repeat units of the general formulae (II) and (III) or the repeat units of the general formulae (I), (II) and (III) may each be the same or different within a polythiophene. Preference is given to polythiophenes having in each case identical repeat units of the general formula (I) or of the general formula (II) or of the general formula (III) or having in each case identical repeat units of the general formulae (I) and (II), or of the general formulae (I) and (III), or of the general formulae (II) and (III), or having in each case identical repeat units of the general formulae (I), (II) and (III). Particular preference is given to polythiophenes having in each case identical repeat units of the general formula (I) or of the general formula (II) or having in each case identical repeat units of the general formulae (I) and (II). At the end groups, the polythiophenes preferably each bear H.

In the context of the invention, $C_1$-$C_5$-alkylene radicals A are preferably methylene, ethylene, n-propylene, n-butylene or n-pentylene. $C_1$-$C_{18}$-Alkyl R is preferably linear or branched $C_1$-$C_{18}$-alkyl radicals such as methyl, ethyl, n- or isopropyl, n-, iso-, sec- or tert-butyl, n-pentyl, 1-methylbutyl, 2-methylbutyl, 3-methylbutyl, 1-ethylpropyl, 1,1-dimethylpropyl, 1,2-dimethylpropyl, 2,2-dimethylpropyl, n-hexyl, n-heptyl, n-octyl, 2-ethylhexyl, n-nonyl, n-decyl, n-undecyl, n-dodecyl, n-tridecyl, n-tetradecyl, n-hexadecyl or n-octadecyl, $C_5$-$C_{12}$-cycloalkyl radicals R are, for example, cyclopentyl, cyclohexyl, cycloheptyl, cyclooctyl, cyclononyl or cyclodecyl, $C_6$-$C_{14}$-aryl radicals R are, for example, phenyl or naphthyl, and $C_7$-$C_{18}$-aralkyl radicals R are, for example, benzyl, o-, m-, p-tolyl, 2,3-, 2,4-, 2,5-, 2,6-, 3,4-, 3,5-xylyl or mesityl. The above list serves to illustrate the invention by way of example and should not be considered to be exclusive.

In the context of the invention, any further substituents of the A radicals and/or of the R radicals include numerous organic groups, for example alkyl, cycloalkyl, aryl, aralkyl, alkoxy, halogen, ether, thioether, disulfide, sulfoxide, sulfone, sulfonate, amino, aldehyde, keto, carboxylic ester, carboxylic acid, carbonate, carboxylate, cyano, alkylsilane and alkoxysilane groups, and also carboxamide groups.

The polythiophenes may be uncharged or cationic. In preferred embodiments, they are cationic, "*cationic*" relating only to the charges which reside on the main polythiophene chain. According to the substituent on the R radicals, the polythiophenes may bear positive and negative charges in the structural unit, in which case the positive charges are on the main polythiophene chain and the negative charges are, if present, on the R radicals substituted by sulfonate or carboxylate groups. The positive charges of the main polythiophene chain may be partly or fully saturated by the anionic groups which may be present on the R radicals. Viewed overall, the polythiophenes in these cases may be cationic, uncharged or even anionic. Nevertheless, in the context of the invention, all are considered to be cationic polythiophenes, since the positive charges on the main polythiophene chain are crucial. The positive charges are not shown in the formulae, since their exact number and position cannot be stated unambiguously. The number of positive charges is, however, at least 1 and at most n, where n is the total number of all repeat units (identical or different) within the polythiophene.

The positive charge of the polythiophenes can be balanced by sulfonate- or carboxylate-substituted and thus negatively charged R radicals (so called "self-doped polythiophenes") or by counter-ions (so called "*foreign-doped polythiophenes*").

According to a first preferred embodiment of the polythiophenes in the dispersion according to the present invention the polythiophenes are self-doped polythiophenes that preferably comprise, to the extent of at least 50 %, still more preferably to the extent of at least 75 %, still more preferably to the extent of at least 95 % and most preferably to the extent of 100 %, recurring units of the formula (IV)

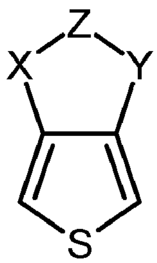

(IV)

in which

X,Y are identical or different and denote O, S, N-$R^1$, wherein $R^1$ denotes aryl, $C_1$-$C_{18}$-alkyl or hydrogen;
Z is an organic group carrying an anionic functional group, preferably a $SO_3^-$ group, wherein it is particualrly preferred that Z denotes $-(CH_2)_m-CR^2R^3-(CH_2)_n-$,
$R^2$ denotes hydrogen, $-(CH_2)_s-O-(CR^4{}_2)_p-SO_3^-M^+$ or $-(CH_2)_p-SO_3^-M^+$,
$R^3$ denotes $-(CH_2)_s-O-(C R^4{}_2)_p-SO_3^-M^+$ or $-(CH_2)_p-SO_3^-M^+$,
$M^+$ denotes a cation,
m,n are identical or different and denote an integer from 0 to 3,
$R^4$ denotes hydrogen or a $C_1$-$C_{10}$ alkyl group, preferably a methyl group,
s denotes an integer from 0 to 10 and
p denotes an integer from 1 to 18.

The percentage figures stated above are intended in this context to express the numerical content of the units of the structural formula (IV) in the total number of monomer units in the self-doped conductive polymer.

Suitable cations $M^+$ are e.g. $H^+$, $Li^+$, $Na^+$, $K^+$, $Rb^+$, $Cs^+$ and $NH_4^+$. Particularly suitable cations are $Na^+$ and $K^+$.

Particularly preferred monomers of the structural formula (IV) are those in which

X,Y denote O,
Z denotes $-(CH_2)_m-CR^2R^3-(CH_2)_n-$,
$R^2$ denotes hydrogen or $-(CH_2)_s-O-(CH_2)_p-SO_3^-M^+$, $-(CH_2)_p-SO_3^-{}_M{}^+$ or $-(CH_2)_s-O-(CH_2)_p-CHR^4-SO_3^-M^+$,
$R^3$ denotes $-(CH_2)_sO-(CH_2)_p-SO_3^-M+$, $-(CH_2)_p-SO_3^-M^+$ or $-(CH_2)_s-O-(CH_2)_p-CHR^4-SO_3^-M^+$,
$M^+$ denotes a cation,
m,n are identical or different and denote an integer from 0 to 3,
$R^4$ denotes hydrogen a methyl group or an ethyl group;
s denotes an integer from 0 to 10 and

p denotes an integer from 1 to 18.

Very particularly preferred monomers of the structural formula (IV) are those in which

X,Y denote O,

Z denotes $-(CH_2)-CR^2R^3-(CH_2)_n-$,

$R^2$ denotes hydrogen,

$R^3$ denotes $-(CH_2)i_s-O-(CH2)_p-SO_3^-M^+$, $-(CH_2)_p-SO_3^-M^+$, or $-(CH_2)_s-O-(CH_2)_p-CH(CH_3)-SO_3^-M^+$ or $-(CH_2)_s-O-(CH_2)_p-CH(CH_2CH_3)-SO_3^{-}-M^+$,

$M^+$ denotes $Na^+$ or $K^+$,

n denotes 0 or 1,

s denotes 0 or 1 and

p denotes 2, 3, 4 or 5.

Suitable Examples of self-doped polymers are disclosed in WO-A-2014/048562 and in US-A-2015/0337061. Concrete examples of very particularly preferred self-doped conductive polymers include poly(4-[(2,3-dihydrothieno[3,4-b]-[1,4]dioxin-2-yl)methoxy]propane-1-sulfonic acid), poly(4-[(2,3-dihydrothieno-[3,4-b][1,4]dioxin-2-yl)methoxy]butane-1-sulfonic acid) (PEDOT-S), poly(4-[(2,3-dihydrothieno[3,4-b][1,4]dioxin-2-yl)methoxy]butane-2-sulfonic acid) or a mixture thereof.

According to a second preferred embodiment of the polythiophenes in the dispersion according to the present invention, the polythiophenes are foreign-doped polythiophenes that preferably comprise polymeric counter-ions to balance the positive charges, the latter also being referred to hereinafter as "polyanions". Thus, according to a preferred embodiment of the dispersion according to the present invention the polythiophene is a cationic polythiophene that comprises a polyanions serving as a counter-ion for the polythiophene.

Polyanions are preferred over monomeric anions, since they contribute to film formation and, owing to their size, lead to thermally more stable, electrically conductive films. Polyanions here may, for example, be anions of polymeric carboxylic acids, such as polyacrylic acids, polymethacrylic acid or polymaleic acids, or polymeric sulfonic acids, such as polystyrenesulfonic acids and polyvinylsulfonic acids. These polycarboxylic and -sulfonic acids may also be copolymers of vinylcarboxylic and vinylsulfonic acids with other polymerizable monomers, such as acrylic esters and styrene.

A preferred polyanion is an anion of a polymeric carboxylic or sulfonic acid. A particularly preferred polyanion is the anion of polystyrenesulfonic acid (PSS) or a derivative thereof.

The molecular weight of the polyacids which afford the polyanions is preferably 1000 to 2000000, more preferably 2000 to 500000. The polyacids or alkali metal salts thereof are commercially available, for example polystyrenesulfonic acids and polyacrylic acids, or else are preparable by known processes (see, for example, Houben Weyl, Methoden der organischen Chemie [Methods of Organic Chemistry], vol. E 20 Makromolekulare Stoffe [Macromolecular Substances], part 2, (1987), p. 1141 ff.).

A concrete example of very particularly preferred foreign-doped polythiophene is a complex of poly(3,4-ethylenedioxythiophene) and an anion of polystyrenesulfonic acid (PEDOT/PSS).

Further additives

According to a preferred embodiment of the dispersion according to the invention, the dispersion further comprises at least one additive, wherein the at least one additive is an additive selected from the group consisting of a binder, a pH-regulator, a crosslinker, an adhesion promoter, a conductivity improver, a surfactant, a stabilizer and a combination of at least two of these additives.

- Suitable binders comprise organic binders which in particular are soluble in organic solvents, such as polyolefins, polyvinyl acetate, polycarbonate, polyvinyl butyral, polyacrylic acid esters, polyacrylic acid amides, polymethacrylic acid esters, polymethacrylic acid amides, polystyrene, polyacrylonitrile, polyvinyl chloride, polyvinyl pyrrolidones, polybutadiene, polyisoprene, polyethers, polyesters, polyurethanes, polyamides, polyimides, polysulphones, polysilicones, epoxy resins, styrene-acrylate, vinyl acetate/acrylate and ethylene/vinyl acetate copolymers, polyvinyl

alcohols or cellulose derivatives, can also be added to the composition. Also suitable as binders are copolymers of the above-mentioned polymers.

- Suitable pH-regulators comprise the bases or acids that, for example, are described on page 4, lines 13-32 of WO 2010/003874 A2. Preferred are such additives that do not impair the film formation of the dispersion and are not volatile at relatively high temperatures, for example, at soldering temperatures, but remain within the solid electrolyte under these conditions. Particularly suitable are compounds such as the bases 2-dimethyl-aminoethanol, 2,2'-iminodiethanol or 2,2',2"-nitrilotriethanol and the acid polystyrene sulfonic acid.

- Suitable crosslinkers comprise melamine compounds, capped isocyanates, functional silanes, for example tetraethoxysilane, alkoxysilane hydrolysates for example based on tetraethoxysilane, or epoxysilanes such as 3-glycidoxypropyl trialkoxysilane.

- Suitable adhesion promoters comprise organo-functional silanes or their hydrolysates, for example, 3-glycidoxypropyltrialkoxysilane, 3-amino-propyl-triethoxysilane, 3-mercaptopropyltrimethoxysilane, 3-methacryl-oxypropyl-trimethoxysilane, vinyltrimethoxysilane or octyltriethoxysilane.

- Suitable conductivity improver comprise compounds such as for example tetrahydrofuran, lactone group-comprising compounds such as butyrolactone, valerolactone, amide group- or lactam group-comprising compounds such as caprolactam, N-methyl caprolactam, N,N-dimethyl acetamide, N-methyl acetamide, N,N-dimethyl formamide (DMF), N-methyl formamide, N-methyl formanilide, N-methyl pyrrolidone (NMP), N-octyl pyrrolidone, pyrrolidone, sulphones and sulphoxides, such as for example sulpholane (tetramethylene sulphone), dimethyl sulphoxide (DMSO), sugar or sugar derivatives, such as for example sucrose, glucose, fructose, lactose, sugar based surfactants such as Tween or Span 60, sugar alcohols such as for example sorbitol, mannitol, furan derivatives such as for example 2-furan carboxylic acid, 3-furan carboxylic acid, and/or di- or polyalcohols such as for example ethylene glycol, glycerol, di- or triethylene glycol or polyglycerols. Ethylene glycol, diethylene glycol, triethylene glycol, polyglycerols, dimethyl sulphoxide or sorbitol are particularly preferably used as conductivity-improving additives.

- Suitable surfactants include anionic surfactants, such as e.g. alkylbenzenesulphonic acids and salts, paraffin sulphonates, alcohol sulphonates, ether sulphonates, sulphosuccinates, phosphate esters, alkyl ether carboxylic acids or carboxylates, cationic surfactants, such as *e.g.* quaternary alkylammonium salts, nonionic surfactants, in particular non-ionic amphiphilic surfactants, such as e.g. linear or branched alcohol ethoxylates, oxo alcohol ethoxylates, alkylphenol ethoxylates or alkyl polyglucosides. Representative examples of suitable surfactants include fluorosurfactants such as ZONYL® surfactants, including ZONYL® FSN, ZONYL® FSO, ZONYL® FSA, ZONYL® FSH (DuPont Chemicals, Wilmington, Del.), and NOVEC® (3M, St. Paul, Minn.). Other exemplary surfactants include non-ionic surfactants based on alkylphenol ethoxylates. Preferred surfactants include, for example, octylphenol ethoxylates such as TRITON®, and secondary alcohol ethoxylates such as TERGITOL® 15-S series (Dow Chemical Company, Midland Mich.). Further exemplary non-ionic surfactants include acetylenic-based surfactants, n-dodecyl β-D-maitoside and alcohol ethoxylates such as TERGITOL® TMN.

- Suitable stabilisers are those compounds which are mentioned in WO 2012/041507 A1, wherein aromatic compounds containing at least two OH groups and one further functional group with a hetero atom which differs from carbon are particularly preferred. Examples of suitable stabilizers are 3,4,5-trihydroxybenzoic acid and derivatives thereof like 3,4,5-trihydroxybenzoic acid esters (gallic acid esters), in particular alkyl esters, alkenyl esters, cycloalkyl esters, cycloalkenyl esters, aryl esters, having preferably in each case 1 to 15 C atoms in the aryl or alkyl groups of the esters, are furthermore to be mentioned. Particularly preferred are gallic acids and gallic acids esterified with sugars, which are often called tannin or gallotannins (cf. Römpp Chemie, 10th edition (1999), page 4391). Also suitable as stabilizers are the "*hydroxy-group-containing aromatic compounds*" that are mentioned in paragraph [0049] of EP 1 798 259 A1, the "*anti-oxidants*" that are mentioned in paragraph [0025] of EP 1 043 720 A1 and the "*aromatic compounds exclusive of sulfo groups and containing at least two hydroxy groups*" that are mentioned on pages 10 and 11 of WO 2008/055834 A1.

Process for producing a capacitor

According to a preferred embodiment of the process for the preparation of a layered body according to the present invention, the layered body is part of an electrolyte capacitor. In this case, the process comprises the steps of

**A)** provision of a porous electrode body made of an electrode material, wherein a dielectric layer at least partially

covers a surface of this electrode material;

**B)** introduction of the dispersion according to the present invention, preferably of the dispersion according to the present invention as defined in any of its 1st to the 16th embodiment, or of a dispersion obtainable by process 1 according to the present invention, preferably by process 1 as defined in any of its 1st to the 8th embodiment, into at least a part of the porous electrode body provided in process step **A)** so as to apply the dispersion onto and at least a part of the surface of the dielectric layer;

**C)** at least partial removal of the dispersant **i)** for the formation of a solid electrolyte layer that at least partially covers a surface of the dielectric layer;

**D)** optionally application of a dispersion containing a conductive polymer, preferably a dispersion comprising a polythiophene and a dispersant, more preferably a dispersion comprising a dispersant and particles of a complex of a polythiophene and a polymeric anion, even more preferably a PEDOT/PSS-dispersion, onto at least a part of the surface of the solid electrolyte layer and at least partial removal of the dispersant for the formation of a polymeric outer layer that at least partially covers a surface of the solid electrolyte layer;

**E)** optionally filling at least a part of the pores of the porous electrode body obtained in process step **C)** or in process step **D)** (*i. e.*, the porous electrode body in which the surface of the dielectric layer is at least partially covered with a solid electrolyte layer) with an impregnation solution comprising at least one impregnation solvent.

Process step **A)**:

In process step **A)** a porous electrode body made of an electrode material is provided, wherein a dielectric layer at least partially covers a surface of this electrode material.

In principle, the porous electrode body can be manufactured in that a valve-metal powder with a high surface area is pressed and sintered to form a porous electrode body. In this context, an electrical contact wire preferably made from a valve metal, such as tantalum, is conventionally pressed into the porous electrode body. The porous electrode body is then coated with a dielectric, that is, an oxide layer, for example, by electrochemical oxidation. As an alternative, metal films can be etched and coated with a dielectric by electrochemical oxidation in order to obtain an anode film with a porous region. In the case of a wound capacitor, an anode film with a porous region, which forms the electrode body, and a cathode film are separated by separators and wound up.

Within the scope of the invention, metals of which the oxide coatings do not allow the flow of current uniformly in both directions are understood as valve metals. With a voltage applied at the anode, the oxide layers of the valve metals block the flow of current, while in the case of a voltage applied to the cathode, considerable currents occur, which can destroy the oxide layer. The valve metals include Be, Mg, Al, Ge, Si, Sn, Sb, Bi, Ti, Zr, Hf, V, Nb, Ta and Wand an alloy or compound of at least one of these metals with other elements. The most well-known representatives of the valve metals are Al, Ta and Nb. Combinations of electrical properties comparable with a valve metal are those with metallic conductivity, which can be oxidised and of which the oxide layers provide the properties described above. For example, NbO shows metallic conductivity, but is not generally regarded as a valve metal. However, layers of oxidised NbO show the typical properties of valve-metal oxide layers, so that NbO or an alloy or compound of NbO with other elements are typical examples of such compounds with electrical properties comparable with a valve metal. Electrode materials made of tantalum, aluminium and such electrode materials which are based on niobium or niobium oxide are preferred. Aluminium is particularly preferred as an electrode material.

For the manufacture of the porous electrode body often with a porous region, the valve metals can be sintered, for example, in powdered form to provide a generally porous electrode body, or alternatively, a porous structure is imprinted onto a metallic body. The latter can be implemented, for example, by etching a film.

In the following, for the sake of simplicity, bodies with a porous region are also referred to as porous. For example, electrode bodies with a porous region are also referred to as porous electrode bodies. On the one hand, the porous bodies can be penetrated by a plurality of channels and therefore be sponge-like. This is often the case if tantalum is used in the construction of the capacitor. On the other hand, pores can be present only at the surface, and the region disposed below the surface pores can be formed in a solid manner. This is often observed, if aluminium is used in the capacitor construction.

The porous electrode bodies manufactured in this manner are then oxidised, for example in an appropriate electrolyte, for example, phosphoric acid or an aqueous solution of ammonium adipate, by applying a voltage, in order to form the dielectric. The magnitude of this forming voltage is dependent upon the oxide-layer thickness to be achieved or respectively the subsequent operating voltage of the capacitor. Preferred forming voltages lie in a range of from 1 to 1000 V, particularly preferably in a range of from 10 to 200 V, more particularly preferably in a range of from 15-100 V,

more preferably in a range of from 20-50 V.

The porous electrode bodies used preferably have a porosity of 10 to 90 %, preferably of 30 to 80 %, particularly preferably of 50 to 80 %, and an average pore diameter of from 10 to 10000 nm, preferably from 50 to 5000 nm, particularly preferably from 100 to 3000 nm.

According to a special embodiment of the process according to the invention, the electrolytic capacitor to be manufactured is an aluminium wound capacitor. In this case, in process step **A)**, a porous aluminium film as electrode material is formed anodically, whereby an aluminium-oxide coating is formed as the dielectric. The aluminium film (anode film) thus obtained is then provided with a contact wire and wound up with a further porous aluminium film (cathode film) also provided with a contact wire, whereby these two films are separated from one another by one or more separator papers, which are based, for example, on cellulose or preferably on synthetic papers. After the winding, the anode bodies obtained in this manner are fixed, for example, by means of an adhesive tape. The separator paper or papers can be carbonised by heating in an oven. This manner of manufacturing anode bodies for aluminium wound capacitors is sufficiently known from the prior art and is described, for example in US 7,497,879 B2.

Process steps **B)** and **C)**:

In process step **B)** of the process according to the invention, the dispersion according to the present invention, preferably the dispersion according to the present invention as defined in any of its 1st to the 16th embodiment, or the dispersion obtainable by process 1 according to the present invention, preferably by process 1 as defined in any of its 1st to the 8th embodiment, is introduced into at least a part of the porous electrode body provided in process step **A).** In process step **C)** the dispersant **i)** is then at least partially removed for the formation of a solid electrolyte layer that at least partially covers a surface of the dielectric layer.

The dispersion is introduced into the porous region using known processes, for example, immersion, dipping, pouring, dripping, injection, spraying, spreading, painting or printing, for example, ink-jet printing, screen printing or tampon printing. The introduction is preferably carried out in that the porous electrode body provided in process step **A)** is immersed in the dispersion and is accordingly impregnated with this dispersion. The immersion into or the impregnation with the dispersion is preferably implemented for a duration in a range of from 1 second to 120 min, particularly preferably in a range of from 10 seconds to 60 min and most preferably in a range of from 30 seconds to 15 min. The introduction of the dispersion into the anode body can be facilitated, for example, by increased or reduced pressure, vibration, ultrasound or heat.

After the porous electrode bodies have been impregnated with the dispersion as described above, the dispersant **i)** is at least partially removed in process step **C)**, so that a solid electrolyte layer is formed, which covers the dielectric partially or completely. In this context, it is preferable that the covering of the dielectric by the solid electrolyte layer preferably amounts to at least 50 %, particularly preferably at least 70 % and most preferably at least 80 %, wherein the measurement of the capacitance of the capacitor in a dry and wet condition at 120°C allows a determination as described in DE-A-10 2005 043 828.

The removal of the dispersant **i)** is preferably carried out in that the porous electrode body is removed from the dispersion used in process step **B)** and is subsequently dried, wherein the drying preferably takes place at a temperature in a range from 20°C to 200°C, particularly preferably in a range from 50°C to 180°C and more preferably in a range from 80°C to 150°C. The drying conditions (*i. e.* drying time, drying pressure and drying temperature) are preferably adjusted to be within a range that ensures that at least 50 wt.-%, more preferably at least 75 wt.-%, even more preferably at least 90 wt.-%, even more preferably at least 95 wt.-% and most preferably at least 99 wt.-% of the total amount of the dispersant **i)** is removed when forming the solid electrolyte layer. In a particularly preferred embodiment of the process according to the present invention the drying conditions are adjusted to be within a range that ensures that the dispersant **i)** is completely removed when forming the solid electrolyte layer.

Process step **D)**:

In process step **D)** a dispersion containing a conductive polymer, preferably a dispersion comprising a polythiophene and a dispersant, more preferably a dispersion comprising a dispersant and particles of a complex of a polythiophene and a polymeric anion, even more preferably a PEDOT/PSS-dispersion, may be applied onto at least a part of the surface of the solid electrolyte layer, followed by an at least partial removal of the dispersant for the formation of a polymeric outer layer that at least partially covers the surface of the solid electrolyte layer (as disclosed, for example, in DE 10 2004 022 674 A1). The term "*polymeric outer*" layer as used herein preferably refers to an outer layer that, although it may comprise the very same conductive polymer as the solid electrolyte layer, nevertheless differs from the solid electrolyte layer with respect to, for example, the chemical composition, the conductivity and/or a property such as the hardness, the surface roughness, the adhesion property *etc.*. The polymeric outer layer, usually having a thickness in the range from 5 to 50 μm, serves as a mechanical buffer between the capacitor anode and the cathode-side contact,

preventing the cathode-side-contact to come into contact with the dielectric under mechanical stresses that may occur during the manufacture of the capacitor.

Before applying a dispersion containing a conductive polymer onto at least a part of the surface of the solid electrolyte layer in process step **D)**, it may also be advantageous to apply a crosslinker onto at least a part of the surface of the solid electrolyte layer in order to improve the coverage of the capacitor anode by the polymeric outer layer. Suitable crosslinkers and processes for their application are, for example, disclosed in DE 10 2009 007 594 A1.

Process step **E)**:

In process step **E)** of the process according to the invention at least a part of the pores of the porous electrode body obtained in process step **C)** (*i. e.*, the porous electrode body in which the dielectric layer is at least partially covered with a solid electrolyte layer) can be filled with an impregnation solution comprising at least one impregnation solvent.

The immersion in or respectively the impregnation with the impregnation solution is preferably implemented for a duration in a range of from 1 second to 120 min, particularly preferably in a range of from 10 seconds to 60 min and most preferably in a range of from 30 seconds to 15 min. The immersion is preferably carried out in that the porous electrode body obtained in process step **C)** is immersed at least partially in the impregnation solution or the impregnation solution is injected into the porous electrode body and is accordingly impregnated with this impregnation solution. The introduction of the impregnation solution into the porous electrode body can be facilitated, for example, by increased or reduced pressure, vibration, ultrasound or heat.

In process step **E)** it is particularly preferred that the impregnation solution is applied immediately before performing process step **F)** described below, *i. e*. before encapsulating the porous electrode body in order to prevent evaporation of the impregnation solvent out of the pores. The impregnation solution applied in process step **E)** thus remains - at least to a certain extent, preferably completely - within the pores of the porous electrode body before it is encapsulated.

Examples of the impregnation solvent include a sulfone compound, a lactone compound, a carbonate compound, and a polyhydric alcohol. The impregnation solvent may be used singly or in combination of two or more kinds thereof.

Examples of the sulfone compound include sulfolane, dimethyl sulfoxide, and diethyl sulfoxide. Examples of the lactone compound include γ-butyrolactone and γ-valerolactone. Examples of the carbonate compound include dimethyl carbonate, diethyl carbonate, ethyl methyl carbonate, ethylene carbonate, propylene carbonate, and fluoroethylene carbonate. Examples of the polyhydric alcohol include a glycerin compound, a sugar alcohol compound, and a glycol compound. Examples of the glycerin compound include glycerin, polyglycerin (diglycerin, triglycerin, etc.), and derivatives thereof. Examples of the glycol compound include an alkylene glycol (C2-4 alkylene glycol (ethylene glycol, propylene glycol, etc.), and the like), a polyalkylene glycol (poly C2-4 alkylene glycol (diethylene glycol, dipropylene glycol, triethylene glycol, polyethylene glycol, etc.), and the like).

The impregnation solution may include a solute. Examples of the solute include an acid component, such as carboxylic acids, sulfur-containing acids, boron-containing acids and phosphorus-containing acids, and a base component, such as ammonia, amine, a quaternary ammonium compound and an amidinium compound.

The liquid component may include the acid component and the base component in a free state or in a salt form, respectively. The liquid component may include an organic salt. Examples of the organic salt include those in which at least one of the acid component and the base component is organic.

The concentration of the solute in the liquid component is, for example, in a range from 0.1 to 25 wt.-%, inclusive, and may be in a range from 0.5 to 15 wt.-%, inclusive.

Encapsulation in process step **F)**:

After in process step **C)** at least a part of the dispersant **i)** has been removed or - if process step **D)** and/or process step **E)** are performed - after in process step **D)** a polymeric outer layer has been applied or after in process step **E)** at least a part of the pores of the porous electrode body obtained in process step **C)** has been filled with an impregnation solution, the electrolytic capacitors can be finished, particularly encapsulated, in a manner known to the person skilled in the art. In the case of a tantalum electrolytic capacitor, the capacitor body can be coated, for example, with a graphite layer and a silver layer, as known from DE-A-10 2005 043 828, while in the case of an aluminium wound capacitor corresponding to the teaching of US 7,497,879 B2, the capacitor body is built into an aluminium cup, provided with a sealing rubber and firmly closed in a mechanical manner by flanging.

Encapsulation is preferably accomplished by sealing the capacitor body with resins, such as epoxy resins or thermoplastic resins like those disclosed in EP 0 447 165 A2. In case of an aluminium electrolytic capacitor encapsulation is preferably accomplished by providing the porous electrode body obtained in process step e) with the aluminium cup and closing it with the sealing rubber.

The features disclosed in the claims, the specification, and the drawings maybe essential for different embodiments of the claimed invention, both separately and in any combination with each other.

**DESCRIPTION OF THE DRAWINGS**

The following schematic drawings show aspects of the invention for improving the understanding of the invention in connection with some exemplary illustrations.

Figure 1 shows the structure of a layer body 100 prepared by the process for the preparation of a layered structure according to the invention, for example an antistatic film, in general form. On the substrate surface of a substrate 101, in the case of an antistatic film often a PE, PP or PET layer, is an electrically conductive layer 102 that has been prepared with the composition according to the invention.

Fig. 2 shows a schematic sectional view through a part of a capacitor obtained by a particular embodiment of the process for the preparation of a layered structure according to the invention. The capacitor comprises a porous electrode body 101a comprising pores 103, made mostly from a porous electrode material 101b such as aluminium. On the surface of the electrode material 101b, a dielectric layer 101c is formed as a thin layer, so that an anode body is formed which is still porous, comprising the electrode body 101a made of the electrode material 101b and the dielectric layer 101c. On the dielectric layer 101c, there follows, optionally after further layers, a layer of a solid electrolyte layer 102a (that has been prepared using the dispersion according to the present invention), so that a capacitor body is formed, comprising the electrode body 101a made of the electrode material 101b, the dielectric layer 101c and the solid electrolyte layer 102a.

MEASUREMENT METHODS:

<u>Solids content</u>

An empty weighing bottle with cap (diameter 50 mm) is weighed out using an analytical balance (weight **A**). About 5 g of dispersion is filled into the empty weighing bottle and weighed with cap (weight **B**). The open weighing bottle and the cap are transferred separately to a drying cabinet and dried 15 -16 hours at 100°C.

After drying the weighing bottle is directly sealed with the cap and cooled down to room temperature with the cap on. The weighing bottle is then weighed with cap. (weight C) The measurement is repeated with a new sample a second time.

The solid content is calculated according to:

$$\text{wt.-\% solids} = (\mathbf{C} - \mathbf{A}) \times 100 / (\mathbf{B} - \mathbf{A})$$

The solid content measurement is done as two separate measurements. The two solid content measurements are allowed to differ up to a maximum of 0.03%. In case the difference is larger the measurement has to be repeated.

The final value is the average of the two single measurements.

<u>Conductivity</u>

For the measurement of electrical conductivity 19 g of the dispersion to be analyzed are mixed with 1 g of DMSO in a beaker and stirred for 10 min. The electrical conductivity means the inverse of the specific resistance. The specific resistance is calculated from the product of surface resistance and layer thickness of the conductive polymer layer. The surface resistance is determined for conductive polymers in accordance with DIN EN ISO 3915. The mixture of polymer dispersion and DMSO is applied as a homogeneous film by means of a spin coater to a glass substrate 50 mm × 50 mm in size which was thoroughly cleaned. The coating composition is applied to the substrate by means of a pipette to completely cover the area and spun off directly by spin coating. The spin conditions for coating compositions were 20 s at approx. 1,000 rpm in air. Thereafter, a drying process on a hot-plate was carried out (15 min at 130 °C in air). Silver electrodes of 2.0 cm length at a distance of 2.0 cm are vapor-deposited on to the polymer layer via a shadow

mask. The square region of the layer between the electrodes is then separated electrically from the remainder of the layer by scratching two lines with a scalpel. The surface resistance is measured between the Ag electrodes with the aid of an ohmmeter (Keithley 614). The thickness of the polymer layer is determined with the aid of a Stylus Profilometer (Dektac 150, Veeco) at the places scratched away.

Number of particles

The number of particles is measured using an Accusizer 780 SIS (PSS NICOMP, Particle Sizing Systems, Santa Barbara, California, USA) equipped with an Accusizer 780 SIS software.

7.5 g of the dispersion to be analyzed are diluted with 742.5 g of high purity water. As a result, the concentration is diluted by a factor of 100.

The experimental parameters are set in the following way:

| | |
|---|---|
| Volume Injectables: | Large Volume |
| Number of containers: | 1 |
| Number of Pulls: | 10 |
| Volume of Pull: | 10 ml |
| Tare Volume: | 0 ml |
| Prime Volume: | 2 ml |
| Include first Pull: | Yes |

Channel settings:

| channel | diam. [μm] | max #/ml |
|---|---|---|
| 1 | 1.00 | 10,000 |
| 2 | 1.50 | 5,000 |
| 3 | 5.00 | 1,000 |
| 4 | 10.00 | 500 |
| 5 | 25 | 100 |
| 6 | 50 | 50 |
| 7 | 100 | 20 |

During the measurement the number of particles in 10 × 10 ml of the diluted dispersion are measured. The number of particles > 1.5 μm and the number of particles > 10 μm are recorded. These total numbers for these 10 × 10 ml are reported as number of particles per 1 ml of the original dispersion to be analyzed.

Determination of particle diameter ($\mathbf{d_{50}}$)

The particle diameter is determined as disclosed by H. G. Müller in Colloid Polym. Sci. 267, 1113-1116 (1989). The $d_{50}$ value of the diameter distribution states that 50% of the total weight of all particles of the conductive polymer in the dispersion can be assigned to those particles which have a diameter of less than or equal to the $\mathbf{d_{50}}$-value.

Capacitance (CAP)

The capacitance was determined at 20°C at 120Hz by means of an LCR meter (Agilent 4284A). In each capacitor experiment 4 capacitors have been prepared and the average capacitance value was determined.

EXAMPLES

Example 1

A 3L stainless steel reactor equipped with a stirrer, a vent, a material inlet at the top, an internal thermometer, an ultra-turrax, a material outlet at the bottom and a temperature jacket that was connected to a thermostat was initially charged with 2186 g of deionized water, 102 g of an aqueous polystyrenesulphonic acid solution ($M_W$ 70,000 g/mol; solids content of 25% by weight; total PSS solids 25.5 g). The reaction temperature was kept at 10°C. The mixture was flushed with nitrogen for 3 h. Subsequently the mixture was evacuated to 33 hPa. With running stirrer and ultra-turrax 10.2 g of 3,4-ethylenedioxythiophene (71.8 mmol) were added. The solution was mixed for 30 minutes. Subsequently, 0.06 g of iron(III) sulphate and 19.0 g of sodium persulphate (79.8 mmol) dissolved in 50 g of water were added through the material inlet and the solution was stirred and dispersed for a further 23 h at reduced pressure.

After 23 h the reactor was brought to atmospheric pressure. The inorganic salts were removed using 290 ml of a cation exchanger (Lewatit S108H, Lanxess AG) and 500 ml of an anion exchanger (Lewatit MP 62, Lanxess AG), and the solution was stirred for a further 2 h. The ion exchanger was filtered off. The PEDOT/PSS- dispersion was homogenized three times at a pressure of 1,000 bar with a high-pressure homogenizer. The dispersion was then concentrated to a solids content of 2.4 wt.-% and homogenized 10 times at 1,000 bar to obtain "dispersion **1A**".

47.9 g of dispersion **1A** were mixed with 2 g of ethylene glycol. The pH of the mixture was adjusted to 6 using ammonia. Thus "dispersion **1B**" was obtained (not according to the present invention).

Dispersion **1B** showed the following properties:

| | |
|---|---|
| Number of particles > 1.5 μm per ml: | 52,249 |
| Number of particles > 10 μm per ml: | 8,590 |
| Conductivity: | 390 S/cm |
| Solids content: | 2.3 wt.-% |

Example 2

1 kg of a dispersion identical to dispersion **1A** was filtered through a 10 μm Filter (Pall DFA4001J100). The pressure during the filtration was maintained at below 0.2 bar. Subsequently, the dispersion was filtered through a 0.2 μm Filter (Pall DFA4001NAEY) while maintaining the pressure at 0.3 bar to obtain "dispersion **2A**".

47.9 g of dispersion **2A** were mixed with 2 g of ethylene glycol. The pH of the mixture was adjusted to 6 using an aqueous ammonium hydroxide solution. Thus "dispersion **2B**" was obtained (according to the present invention).

Dispersion **2B** showed the following properties:

| | |
|---|---|
| Number of particles > 1.5 μm per ml: | 2,658 |
| Number of particles > 10 μm per ml: | 449 |
| Conductivity: | 385 S/cm |
| Solids content | 2.3 wt.-% |

Example 3

1 kg of dispersion identical to dispersion **1A** was filtered through a 10 μm Filter (Pall DFA4001J100) to obtain "dispersion **3A**". The pressure during the filtration was maintained at below 0.3 bar. 47.9 g of dispersion **3A** were mixed with 2 g of ethylene glycol. The pH of the mixture was adjusted to 6 using an aqueous ammonium hydroxide solution. Thus "dispersion **3B**" was obtained (not according to the invention).

Dispersion **3B** showed the following properties:

| | |
|---|---|
| Number of particles > 1.5 μm per ml: | 26,234 |
| Number of particles > 10 μm per ml: | 5,129 |
| Conductivity: | 380 S/cm |
| Solids content | 2.3 wt.-% |

Example 4

300 g of dispersion identical to dispersion **1A** was filtered through a 0.2μm filter. (Pall DFA4001 NAEY) at a pressure of 2.5 bar to obtain "dispersion **4A**". 47.9 g of dispersion **4A** were mixed with 2 g of ethylene glycol. The pH of the mixture was adjusted to 6 using an aqueous ammonium hydroxide solution. Thus "dispersion **4B**" was obtained (not according to the invention)

Dispersion **4B** showed the following properties:

| | |
|---|---|
| Number of particles > 1.5 μm per ml: | 13,378 |
| Number of particles > 10 μm per ml: | 1,873 |
| Conductivity: | 366 S/cm |

Example 5

1 kg of a dispersion identical to dispersion **1A** was homogenized 5 times at 2,000 bar. It was then filtered through a 0.2μm filter (Pall DFA4001NAEY) with a pressure of 1.5 bar to obtain "dispersion **5A**". 47.9 g of dispersion **5A** were mixed with 2 g of ethylene glycol. The pH of the mixture was adjusted to 6 using an aqueous ammonium hydroxide solution. Thus "dispersion **5B**" was obtained (not according to the invention).

Dispersion **5B** showed the following properties:

| | |
|---|---|
| Number of particles > 1.5 μm per ml: | 10,539 |
| Number of particles > 10 μm per ml: | 1,387 |
| Conductivity: | 370 S/cm |

Example 6

1 kg of a dispersion identical to dispersion **1A** was homogenized 50 times at 2,000 bar. It was then filtered through a 0.2μm filter (Pall DFA4001NAEY) with a pressure of 0.6 bar to obtain *"dispersion **6A**"*. 47.9 g of dispersion **6A** were mixed with 2 g of ethylene glycol. The pH of the mixture was adjusted to 6 using an aqueous ammonium hydroxide solution. Thus "dispersion **6B**" was obtained (according to the invention).

Dispersion **6B** showed the following properties:

| | |
|---|---|
| Number of particles > 1.5 μm per ml: | 3,409 |
| Number of particles > 10 μm per ml: | 536 |
| Conductivity: | 336 S/cm |
| Solids content | 2.3 wt.-% |

Example 7

1 kg of Clevios P VP Al 4083 (Heraeus Deutschland GmbH & CoKG) was filtered through a 0.2 μm filter (Pall DFA4001 NAEY) to obtain "dispersion **7A**". 47.9 g of dispersion **7A** were mixed with 2 g ethylene glycol. The pH of the mixture was adjusted to 6 using an aqueous ammonium hydroxide solution. Thus "dispersion **7B**" was obtained (not according to the invention).

Dispersion **7B** showed the following properties:

| | |
|---|---|
| Number of particles > 1.5 μm per ml: | 7,492 |
| Number of particles > 10 μm per ml: | 201 |
| Conductivity: | 1 S/cm |

Example 8

500 g of dispersion **6A** were placed in a beaker and continuously filtered over a 0.2 μm filter (Pall DFA4001 NAEY) in a loop in a way that the material coming out of the filter was combined with the dispersion back into the original beaker. The flow rate through the filter was set to 2 L per hour and the filtration of the 500 g was run for 2 h to obtain "dispersion **8A**". 47.9 g of dispersion **8A** were mixed with 2 g of ethylene glycol. The pH of the mixture was adjusted to

6 using an aqueous ammonium hydroxide solution. Thus "dispersion **8B**" was obtained (according to the invention).

Dispersion **8B** showed the following properties

| | |
|---|---|
| Number of particles > 1.5 μm per ml: | 811 |
| Number of particles > 10 μm per ml: | 76 |
| Conductivity: | 338 S/cm |
| Solids content | 2.0 wt.-% |

Example 9

1 kg of a dispersion identical to dispersion **1A** was filtered through a 10 μm Filter (Pall DFA4001J100). The pressure during the filtration was maintained at below 0.2 bar. Subsequently, 500 g of the dispersion was filtered through a 0.45 μm filter (Pall DFA4001NXP) while maintaining the pressure at 0.3 bar to obtain "dispersion **9A**".

47.9 g of dispersion **9A** were mixed with 2 g of ethylene glycol. The pH of the mixture was adjusted to 6 using an aqueous ammonium hydroxide solution. Thus "dispersion **9B**" was obtained (according to the invention).

Dispersion **9B** showed the following properties:

| | |
|---|---|
| Number of particles > 1.5 μm per ml: | 9,540 |
| Number of particles > 10 μm per ml: | 1,913 |
| Conductivity: | 390 S/cm |
| Solids content: | 2.3 wt.-% |

Table 1 summarizes the results of Examples 1 to 9:

| Example | homogenization | filtration 1 pore size [μm] | filtration 2 pore size [μm] | number of particles > 1.5 μm per ml | number of particles > 10 μm per ml | conductivity [S/cm] |
|---|---|---|---|---|---|---|
| 1 (n. i.) | 10 × 1,000 bar | - | - | 52,249 | 8,590 | 390 |
| 2 (i.) | 10 × 1,000 bar | 10 | 0.2 | 2,658 | 449 | 385 |
| 3 (n. i.) | 10 × 1,000 bar | 10 | - | 26,234 | 5,129 | 380 |
| 4 (n. i.) | 10 × 1,000 bar | - | 0.2 | 13,378 | 1,873 | 366 |
| 5 (n. i.) | 10 × 1,000 bar + 5 × 2,000 bar | - | 0.2 | 10,539 | 1,387 | 370 |
| 6 (i.) | 10 × 1,000 bar + 50 × 2,000 bar | - | 0.2 | 3,409 | 563 | 336 |
| 7 (n. i.) | no | 10 | 0.2 | 7,492 | 201 | 1 |
| 8 (i) | 10 × 1,000 bar + 50 × 2,000 bar | - | 0.2 in Loop | 811 | 76 | 338 |
| 9 (i) | 10 × 1,000 bar | 10 | 0.45 | 9,540 | 1,913 | 390 |
| i. = according to the invention; n. i. = non according to the invention | | | | | | |

Process for preparation of capacitors

Process step **A)**:

A porous electrode body for a cylindrical aluminum capacitor (as described in Fig. 2) having a rated voltage of 16 V was produced in the following way. An aluminum foil was etched, thereby to roughen the surface of the aluminum foil. The aluminum foil was then subjected to anodic oxidation using an aqueous ammonium adipate solution, thereby to form a dielectric layer on the surface of the aluminum foil. Thus, an anode foil was produced.

A second aluminum foil was etched, thereby to roughen the surface of the aluminum foil. Thus, a cathode foil was thus prepared.

An anode lead wire and a cathode lead wire were connected to the anode and the cathode foil, respectively. The anode and the cathode foil were wound together with two separator papers between both foils. A tape was put on the outside of the wound element to avoid unwinding of the foils. The wound element was then subjected to another anodic oxidation to form a dielectric layer on the cut edges of the anode foil.

Thus, an anode body comprising an electrode body having a dielectric layer was prepared.

Process step **B)**:

The porous electrode body from process step **A)** was placed into a chamber with a bath of one of the dispersions obtained in Example 1 to Example 9. Air pressure in the chamber was reduced to 100 hPa. The anode body was dipped into the dispersion for 300 s. Then, the anode body was extracted from the dispersion and the chamber was vented to atmospheric pressure.

Process step **C)**:

The anode body was dried at 125°C for 20 min.

Process step **B)** and **C)** were carried out a further time. Thus, a capacitor body was obtained comprising a solid electrolyte layer based on PEDOT/PSS.

Process step **F)**:

The capacitor body of process step **C)** was placed in a cylindrical aluminum housing and sealed with a rubber sealing.

<u>Example 10</u>

First anode bodies according to process step **A)** were prepared. Then, the anode bodies were processed according to process step **B)** and **C)** using dispersion **1B** of Example 1 for the formation of a solid electrolyte layer. Process step **B)** and **C)** were carried out two further times. Thus, a capacitor body was obtained. The capacitor bodies were encapsulated according to process step **F)** to obtain finished capacitors. The average capacitance of the capacitors (not according to the invention) is given in Table 2.

<u>Example 11</u>

Capacitors were produced and evaluated the same way as in Example 10, however, using dispersion **2B** of Example 2 for the formation of a solid electrolyte layer. The average capacitance of the capacitors (according to the invention) is given in Table 2.

<u>Example 12</u>

Capacitors were produced and evaluated the same way as in Example 10, however, using dispersion **3B** of Example 3 for the formation of a solid electrolyte layer. The average capacitance of the capacitors (not according to the invention) is given in Table 2.

<u>Example 13</u>

Capacitors were produced and evaluated the same way as in Example 10, however, using dispersion **4B** of Example 4 for the formation of a solid electrolyte layer. The average capacitance of the capacitors (not according to the invention) is given in Table 2.

<u>Example 14</u>

Capacitors were produced and evaluated the same way as in Example 10, however, using dispersion **5B** of Example 5 for the formation of a solid electrolyte layer. The average capacitance of the capacitors (not according to the invention) is given in Table 2.

Example 15

Capacitors were produced and evaluated the same way as in Example 10, however, using dispersion **6B** of Example 6 for the formation of a solid electrolyte layer. The average capacitance of the capacitors (according to the invention) is given in Table 2.

Example 16

Capacitors were produced and evaluated the same way as in Example 10, however, using dispersion **7B** of Example 7 for the formation of a solid electrolyte layer. The average capacitance of the capacitors is given in Table 2.

Example 17

Capacitors were produced and evaluated the same way as in Example 10, however, using dispersion **8B** of Example 8 for the formation of a solid electrolyte layer. The average capacitance of the capacitors (according to the invention) is given in Table 2.

Example 18

Capacitors were produced and evaluated the same way as in Example 10, however, using dispersion **9B** of Example 9 for the formation of a solid electrolyte layer. The average capacitance of the capacitors (according to the invention) is given in Table 2.

Table 2 summarizes the results of Examples 10 to 18:

| Example | dispersion | number of particles > 1.5 μm per ml | number of particles > 10 μm per ml | conductivity [S/cm] | capacitance [μF] |
|---|---|---|---|---|---|
| 11 (i.) | **2B** | 2,658 | 449 | 385 | 94 |
| 15 (i.) | **6B** | 3,409 | 563 | 336 | 95 |
| 17 (i.) | **8B** | 811 | 76 | 338 | 90 |
| 18 (i.) | **9B** | 9,540 | 1,913 | 390 | 92 |
| 10 (n. i.) | **1B** | 52,249 | 8,590 | 390 | 80 |
| 12 (n. i.) | **3B** | 26,234 | 5,129 | 380 | 82 |
| 13 (n. i.) | **4B** | 13,378 | 1,873 | 366 | 85 |
| 14 (n. i.) | **5B** | 10,539 | 1,307 | 370 | 87 |
| 16 (n. i.) | **7B** | 7,492 | 201 | 1 | 62 |
| i. = according to the invention; n. i. = non according to the invention | | | | | |

**KEY TO REFERENCE NUMBERS**

100 layered body

101 substrate

101a porous electrode body

101b electrode material

101c dielectric layer

102 electrically conductive layer

102a solid electrolyte layer

103 pores

## Claims

1. A dispersion comprising

    **i)** a dispersant;
    **ii)** at least one polythiophene dispersed in the dispersant **i)**;

    wherein the dispersion comprises less than 10,000 particles per ml that have a particle size of 1.5 μm or more; and
    wherein a conductive layer prepared from the dispersion has a conductivity of more than 10 S/cm as determined by the test method disclosed herein.

2. The dispersion according to claim 1, wherein the dispersant **i)** comprises water.

3. The dispersion according to claim 1 or 2, wherein the at least one polythiophene **ii)** is present in the form of particles of a complex comprising the polythiophene and a polyanion.

4. The dispersion according to claim 3, wherein the at least one polythiophene **ii)** is poly(3,4-ethylenedioxythiophene) and wherein the polyanion is an anion of polystyrene sulfonic acid.

5. The dispersion according to claim 3 or 4, wherein the weight average diameter ($\mathbf{d_{50}}$) of particles of the complex comprising a polythiophene and a polyanion is in the range from 1 nm to 100 nm.

6. The dispersion according to any of claim 1 to 5, wherein the dispersion comprises 1,000 to 10,000 particles per ml that have a particle size of 1.5 μm or more.

7. The dispersion according to any of claims 1 to 6, wherein the dispersion comprises less than 2,000 particles per ml that have a particle size of 10 μm or more.

8. The dispersion according to any of claims 1 to 7, wherein the polythiophene is present in the form of particles of a complex comprising the polythiophene and a polyanion and wherein the number and the size of the particles defined in claim 1, 6 and 7 refers to the number and the size of the particles of a complex comprising the polythiophene and a polyanion.

9. The dispersion according to any of claims 1 to 8, wherein a conductive layer prepared from the dispersion has a conductivity of more than 100 S/cm as determined by the test method disclosed herein.

10. The dispersion according to any of claims 1 to 9, wherein the dispersion has a solids content of at least 1 wt.-%, based on the total weight of the dispersion.

11. A process for the preparation of a layered body (100), comprising the process steps:

    **A)** provision of a substrate (101);
    **B)** application of the dispersion according to any of claims 1 to 10 onto at least a part of the surface of this substrate (101);
    **C)** at least partial removal of the dispersant **i)** to obtain a layered body (100) comprising an electrically conductive layer (102) coated onto at least a part of the surface of the substrate (101).

12. The process according to claim 11, wherein the layered body (100) is part of an electrolyte capacitor, wherein the substrate (101) is a porous electrode body (101a) made of an electrode material (101b), wherein a dielectric layer (101c) at least partially covers a surface of this electrode material (101b) and wherein the electrically conductive layer (102) is a solid electrolyte layer (102a) that at least partially covers a surface of the dielectric layer (101c).

**13.** The process according to claim 12, wherein the process comprises the steps of:

**A)** provision of a porous electrode body (101a) made of an electrode material (101b), wherein a dielectric layer (101c) at least partially covers a surface of this electrode material (101b);
**B)** introduction of the dispersion according to any of claims 1 to 10 into at least a part of the porous electrode body (101a) provided in process step **A)** so as to apply the dispersion onto and at least a part of the surface of the dielectric layer (101c);
**C)** at least partial removal of the dispersant **i)** for the formation of a solid electrolyte (102a) that at least partially covers a surface of the dielectric layer (101c).

**14.** A layered body, obtainable by the process according to any of claims 11 to 13.

**15.** Use of the dispersion according to any of claims 1 to 10 for the formation of a solid electrolyte layer in a capacitor.

Fig. 1

100

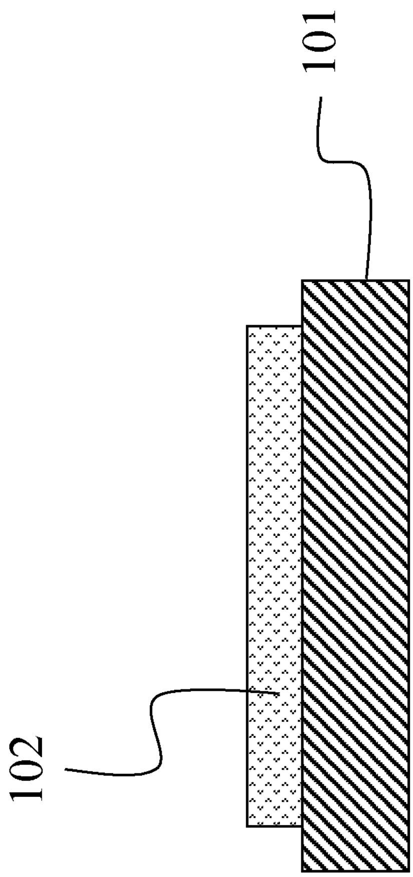

Fig. 2

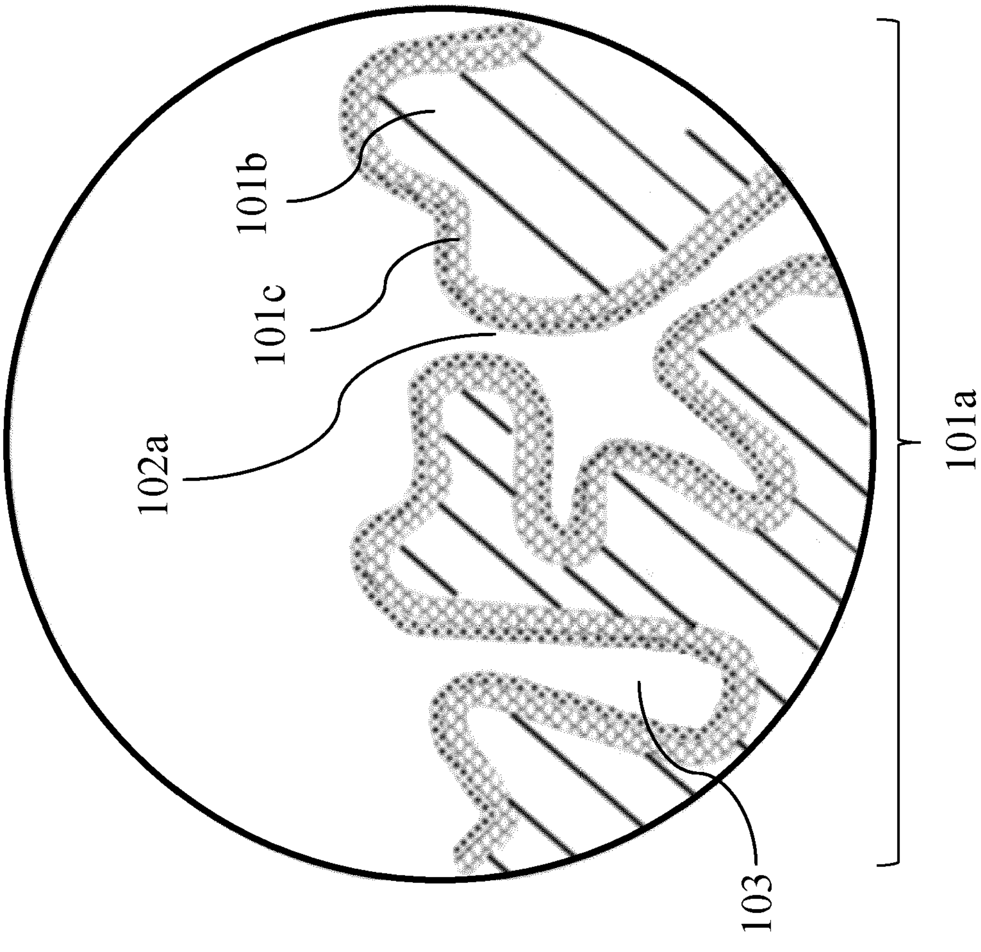

Europäisches Patentamt
European Patent Office
Office européen des brevets

# EUROPEAN SEARCH REPORT

Application Number
EP 23 17 3781

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/279503 A1 (SCHEEL ARNULF [DE] ET AL) 1 October 2015 (2015-10-01)<br>* paragraphs [0013] - [0019], [0049], [0050], [0105], [0110] *<br>----- | 1-15 | INV.<br>H01G9/00<br>H01G9/028<br>H01G9/15 |
| A | US 2014/168857 A1 (SAUTTER ARMIN [DE] ET AL) 19 June 2014 (2014-06-19)<br>* paragraphs [0187] - [0190], [0227] *<br>----- | 1-15 | ADD.<br>H01G11/48<br>H01B1/12<br>C08G61/12 |
| A | US 2023/147032 A1 (MERKER UDO [DE]) 11 May 2023 (2023-05-11)<br>* paragraphs [0109], [0110] *<br>----- | 1-15 | |
| A | US 10 879 010 B2 (KEMET ELECTRONICS CORP [US]) 29 December 2020 (2020-12-29)<br>* column 22, lines 7-28 *<br>----- | 1-15 | |
| | | | TECHNICAL FIELDS SEARCHED (IPC) |
| | | | H01G |

The present search report has been drawn up for all claims

1

| Place of search | Date of completion of the search | Examiner |
|---|---|---|
| Munich | 20 October 2023 | El-Sayed, Tassem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 17 3781

This annex lists the patent family members relating to the patent documents cited in the above-mentioned European search report. The members are as contained in the European Patent Office EDP file on
The European Patent Office is in no way liable for these particulars which are merely given for the purpose of information.

20-10-2023

| Patent document cited in search report | Publication date | Patent family member(s) | Publication date |
|---|---|---|---|
| US 2015279503 A1 | 01-10-2015 | CN 104662629 A | 27-05-2015 |
| | | DE 102012018978 A1 | 27-03-2014 |
| | | EP 2901465 A2 | 05-08-2015 |
| | | HU E052322 T2 | 28-04-2021 |
| | | JP 6654433 B2 | 26-02-2020 |
| | | JP 2015537370 A | 24-12-2015 |
| | | KR 20150063470 A | 09-06-2015 |
| | | PT 2901465 T | 16-02-2021 |
| | | TW 201426786 A | 01-07-2014 |
| | | US 2015279503 A1 | 01-10-2015 |
| | | WO 2014048561 A2 | 03-04-2014 |
| US 2014168857 A1 | 19-06-2014 | CN 103429796 A | 04-12-2013 |
| | | EP 2683855 A1 | 15-01-2014 |
| | | JP 5995262 B2 | 21-09-2016 |
| | | JP 2012186452 A | 27-09-2012 |
| | | KR 20140027131 A | 06-03-2014 |
| | | TW 201248666 A | 01-12-2012 |
| | | US 2014168857 A1 | 19-06-2014 |
| | | WO 2012119711 A1 | 13-09-2012 |
| US 2023147032 A1 | 11-05-2023 | CN 115380344 A | 22-11-2022 |
| | | EP 3889980 A1 | 06-10-2021 |
| | | JP 2023521677 A | 25-05-2023 |
| | | KR 20220161456 A | 06-12-2022 |
| | | TW 202209370 A | 01-03-2022 |
| | | US 2023147032 A1 | 11-05-2023 |
| | | WO 2021198214 A2 | 07-10-2021 |
| US 10879010 B2 | 29-12-2020 | US 2018330888 A1 | 15-11-2018 |
| | | US 2020152393 A1 | 14-05-2020 |
| | | US 2022148816 A1 | 12-05-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 102005043828 A
- WO 2014048562 A
- US 20150337061 A
- WO 2010003874 A2
- WO 2012041507 A1
- EP 1798259 A1
- EP 1043720 A1
- WO 2008055834 A1
- US 7497879 B2
- DE 102004022674 A1
- DE 102009007594 A1


### Non-patent literature cited in the description


- Makromolekulare Stoffe [Macromolecular Substances. **HOUBEN WEYL.** Methoden der organischen Chemie [Methods of Organic Chemistry. 1987, vol. E 20, 1141
- Römpp Chemie. 1999, 4391
- **H. G. MÜLLER.** *Colloid Polym. Sci.,* 1989, vol. 267, 1113-1116